# EUROPEAN PATENT SPECIFICATION

(11) **EP 0 455 339 B1**
(45) Date of publication and mention of the grant of the patent: **16.12.1998**
(21) Application number: 91302575.5
(22) Date of filing: 25.03.1991
(51) Int. Cl.: H01L 23/485

(54) **Polycrystalline silicon contact structure of an SRAM cell**
Polykristallinsilizium-Kontaktstruktur einer SRAM-Zelle
Structure du contact en silicium polycrystallin d'une cellule SRAM

(30) Priority: 30.04.1990 US 516272
(43) Date of publication of application: 06.11.1991
(73) Proprietor: STMicroelectronics, Inc., Carrollton Texas 75006-5039 (US)
(72) Inventor: Brady, James, Dallas, Texas 75252 (US); Chan, Tsiu Chiu, Carrollton, Texas 75006 (US); Culver, David Scott, The Colony, Texas 75056 (US)
(74) Representative: Palmer, Roger

(56) References cited:
- EP-A- 0 032 025
- WO-A-89/05516
- US-A- 4 609 568
- PATENT ABSTRACTS OF JAPAN vol. 9, no. 204 (E-337)21 August 1985 & JP-A-60 068 634 ( NIPPON DENKI KK ) 19 April 1985
- PATENT ABSTRACTS OF JAPAN vol. 12, no. 318 (E-650)29 August 1988 & JP-A-63 081 984 ( NIPPON DENSO ) 12 April 1988

## Description

The present invention is related generally to integrated circuits, and more specifically to a contact between different layers of polycrystalline silicon interconnect.

In semiconductor circuits, it is known that ohmic contacts are desirable between interconnect layers. An ohmic contact is one in which no P-N junction is formed.

When polycrystalline silicon interconnect lines having different conductivity types make contact, a P-N junction is formed. A similar junction can be formed when polycrystalline silicon having the same conductivity type, but very different doping levels (such as N⁻⁻ to N⁺) make contact. For various reasons, it is often desirable to have interconnect having different conductivity types make contact, and it would be desirable to provide an ohmic contact for such structures.

It is therefore an aim of the present invention to provide an ohmic contact between polycristalline silicon interconnect layers of different conductivity types or very different doping levels.

JP-A-60068634 discloses a method of fabricating a semiconductor device in which a high melting point metal layer is formed on a first polycrystalline silicon layer, a heating step is employed to for a silicide layer, and a second polycrystalline silicon layer is formed over the silicide layer.

JP-A-63081984 discloses a method of fabricating a polycrystalline semiconductor diode. The diode comprises a silicon island formed on a semiconductor substrate which is divided into regions of p- and n-type doping.

EP-A-0032025 discloses a static random access memory device including a first polycrystal semiconductor layer which is relatively heavily doped and a second polycrystal semiconductor layer which is relatively lightly doped. Where the second polycrystal semiconductor layer contacts the first polycrystal semiconductor layer or a relatively heavily doped region of a substrate upward diffusion of impurities from the relatively heavily doped parts to the second polycrystal semiconductor layer is provided. Thereby, ohmic contacts with the second polycrystal semiconductor layer can be made, whilst the general light level of doping of the second polycrystal semiconductor layer can be selected so that that layer provides a resistor of a selected value.

It is another aim of the present invention to provide such a contact which is easily formed with a process compatible with existing process technologies.

It is a further aim of the present invention to provide such a contact which is suitable for use in an SRAM structure to provide a load.

The present invention provides an SRAM cell comprising first and second cross-coupled transistors and first and second access transistors, said cross-coupled transistors each being field-effect transistors having respective gates, sources and drains, the gate of said first cross-coupled transistor being connected to the drain of said second cross-coupled transistor and the gate of said second cross-coupled transistor being connected to the drain of said first cross-coupled transistor and first and second load elements respectively connecting the drains of said first and second cross-coupled transistors to a positive voltage supply, characterised in that the first and second load elements each comprise a contact structure comprising a first polycrystalline silicon interconnect layer of a first conductivity type connected to the drain of the respective cross-coupled transistor, a silicide layer on said first polycrystalline silicon layer, an insulating layer overlying said first polycrystalline silicon layer and said silicide layer, said insulating layer having a contact opening therein which exposes a portion of an upper surface of said silicide layer, a second polycrystalline silicon interconnect layer of a second conductivity type overlying a portion of said insulating layer and contacting said silicide layer in the contact opening, wherein an ohmic contact is formed in the contact opening to provide a resistor connection to the drain of the respective cross-coupled transistor and a doped region of a third conductivity type in the second polycrystalline interconnect layer at a location spaced from the contact opening, the doped region of a third conductivity type being more heavily doped than the second polycrystalline interconnect layer and being connected to the positive voltage supply whereby a p-n junction is formed within the second polycrystalline interconnect layer to provide a diode connection between the resistor and the positive voltage supply.

The present also provides a method of fabricating an SRAM cell comprising first and second cross-coupled transistors and first and second access transistors, said cross-coupled transistors each being field-effect transistors having respective gates, sources and drains, the gate of said first cross-coupled transistor being connected to the drain of said second cross-coupled transistor and the gate of said second cross-coupled transistor being connected to the drain of said first cross-coupled transistor and first and second load elements respectively connecting the drains of said first and second cross-coupled transistors to a positive voltage supply, characterised in that the first and second load elements each comprise a contact structure formed by the method steps of forming a first polycrystalline silicon interconnect layer of a first conductivity type, forming a silicide layer on the first polycrystalline silicon interconnect layer, forming an insulating layer over the entire device, forming a contact opening in the insulating layer wherein a contact region on an upper surface of the silicide layer is exposed, forming a second polycrystalline silicon interconnect layer of a second conductivity type over the insulating layer, wherein the second polycrystalline silicon interconnect layer makes ohmic contact with the silicide layer through the contact opening thereby providing a resistor connection to the drain of the respective cross-coupled transistor and forming a doped region of a third conductivity type within the second polycrystalline silicon interconnect layer at a location spaced from the contact opening, the doped region of a third conductivity type being more heavily doped than the second polycrystalline interconnect layer and being connected to the positive voltage supply whereby a p-n junction is formed within the second polycrystalline silicon interconnect layer thereby to provide a diode connection between the resistor and the positive voltage supply.

The novel features believed characteristic of the invention are set forth in the appended claims. The invention itself however, as well as a preferred mode of use, and further objects and advantages thereof, will best be understood by reference to the following detailed description of an illustrative embodiment when read in conjunction with the accompanying drawings, wherein:
Figures 1-3 illustrate a preferred method for forming a contact ; and
Figure 4 is a schematic diagram of an SRAM cell according to the present invention.

The process steps and structures described below do not form a complete process flow for manufacturing integrated circuits. The present invnetion can be practiced in conjunction with integrated circuit fabrication techniques currently used in the art, and only so much of the commonly practiced process steps are included as are necessary for an understanding of the present invention. The figures representing cross-sections of portions of an integrated circuit during fabrication are not drawn to scale, but instead are drawn so as to illustrate the important features of the invention.

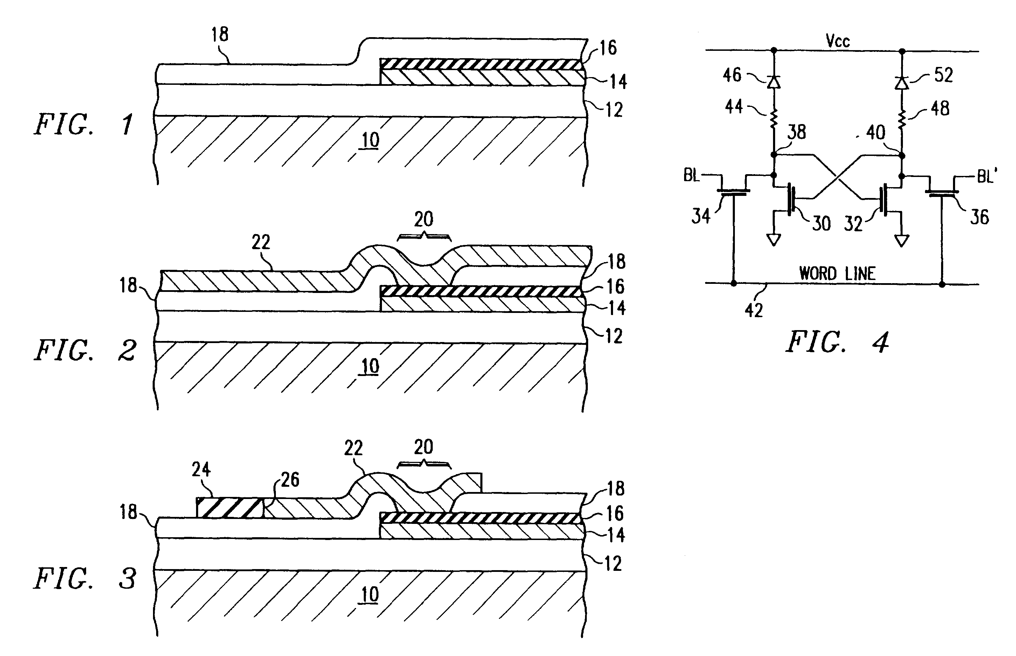

Referring to **Figure 1**, a semiconductor substrate **10** is partially covered with an oxide layer **12**. The oxide layer **12** is not complete over the entire surface of the substrate **10**, but that portion of interest to the present description has no openings to the substrate **10**.

A polycrystalline silicon layer **14** lies on the oxide layer **12**. In the illustrative embodiment, layer **14** is doped N-type. The polycrystalline silicon layer **14** has been silicided to form a silicide layer **16** thereon. The polycrystalline silicon **14** and silicide layer **16** have been patterned in a previous processing step as known in the art to form a signal line. The polycrystalline silicon layer **14** may be a first polycrystalline silicon layer, such as commonly used to form gate electrodes of field effect devices. Alternatively, polycrystalline silicon layer **14** may be a second or later level used for interconnect between different portions of an integrated circuit device. At the processing stage shown in **Figure 1**, the transistors of the device have already been formed.

Once the polycrystalline silicon and silicide layers **14**, **16** have been formed and patterned, an oxide layer **18** is formed over the surface of the device. Oxide layer **18** is typically a thin oxide layer, having a thickness of between 500 and 1000 angstroms (10Å = 1 nm). The thickness of oxide layer **18** may be any thickness which is compatible with the fabrication process with which the invention described herein is being used.

Referring to **Figure 2**, oxide layer **18** is patterned and etched to define a contact opening **20** to the upper surface of the silicide layer **16**. A layer of polycrystalline silicon **22** is then deposited over the surface of the device.

A light dosage of boron is implanted into the polycrystalline silicon layer **22** in order to convert it to a P-type conductor. A typical dosage would be approximately 10¹³ atoms/cm².

Referring to **Figure 3**, the polycrystalline silicon layer **22** is then masked, and a heavy arsenic implant made to define an N⁺ region **24**. A typical dosage for such implant is 5 x 10¹⁵ atoms/cm². Such doping level is used to allow the N⁺ region **24** to be used as a power supply line.

A P-N junction **26** is formed at the interface between the N⁺ region **24** and the lightly P-doped polycrystalline silicon layer **22**. The doping of polycrystalline silicon layer **22** is low enough to define a resistor, but is sufficiently high to cause degeneration in the contact opening **20**, providing an ohmic contact between the polycrystalline silicon layer **22** and the silicide layer **16**. Thus, although the polycrystalline silicon layer **14** is N-type, no P-N junction is formed at the contact between the two layers **14**, **22**.

After formation of the highly doped N⁺ regions **24**, the polycrystalline silicon layer **22** is etched to define interconnect, leaving the structure shown in **Figure 3**. The device is then ready for formation of further oxide and interconnect levels as desired.

Referring to **Figure 4**, a 4-transistor SRAM cell is shown. The contact structure formed in **Figure 1-3** is suitable for use as a load element in the cell of **Figure 4**.

Cross-coupled field effect devices **30**, **32** form the basis of the SRAM cell. Access transistors **34**, **36** connect the bit line BL and complemented bit line BL' to common nodes **38**, **40**, respectively. Access transistors **34**, **36** are driven by the word line **42** as known in the art. Node **38** is connected to the power supply line V_{cc} through resistor **44** and diode **46**. Node **40** is connected to V_{cc} through resistor **48** and diode **50**.

Node **38** corresponds to contact opening **20** in **Figure 3**. Resistor **44** corresponds to polycrystalline silicon region **22** of **Figure 3**, with diode **46** being formed at the junction **26**. Node **40**, resistor **48**, and diode **50** correspond to **Figure 3** in a similar manner.

Since the contact at contact opening **20**, corresponding to nodes **38** and **40**, is an ohmic contact, the load for the SRAM cell is formed by a resistor and a diode rather than back-to-back polycrystalline silicon diodes. In some SRAM cell designs, this can provide improved performance over the use of a resistor alone, or back-to-back polycrystalline silicon diodes.

A similar ohmic contact can be formed between a lower polycrystalline silicon layer which is doped P-type and an upper N-type layer. The silicide layer prevents formation of a P-N junction in the contact opening.

While the invention has been particularly shown and described with reference to a preferred embodiment, it will be understood by those skilled in the art that various changes in form and detail may be made therein without departing from the scope of the invention.

## Claims

1. An SRAM cell comprising:
first and second cross-coupled transistors (30,32) and first and second access transistors (34,36), said cross-coupled transistors (30,32) each being field-effect transistors having respective gates, sources and drains, the gate of said first cross-coupled transistor (30) being connected to the drain of said second cross-coupled transistor (32) and the gate of said second cross-coupled transistor (32) being connected to the drain of said first cross-coupled transistor (30) ; and
first and second load elements respectively connecting the drains of said first and second cross-coupled transistors (30,32) to a positive voltage supply;
characterised in that the first and second load elements each comprise a contact structure comprising:
a first polycrystalline silicon interconnect layer (14) of a first conductivity type connected to the drain of the respective cross-coupled transistor;
a silicide layer (16) on said first polycrystalline silicon layer (14);
an insulating layer (18) overlying said first polycrystalline silicon layer (14) and said silicide layer (16), said insulating layer (18) having a contact opening (20) therein which exposes a portion of an upper surface of said silicide layer (16);
a second polycrystalline silicon interconnect layer (22) of a second conductivity type overlying a portion of said insulating layer (18) and contacting said silicide layer (16) in the contact opening (20), wherein an ohmic contact is formed in the contact opening (20) to provide a resistor connection to the drain of the respective cross-coupled transistor; and
a doped region (24) of a third conductivity type in the second polycrystalline interconnect layer (22) at a location spaced from the contact opening (20), the doped region (24) of a third conductivity type being more heavily doped than the second polycrystalline interconnect layer (2) and being connected to the positive voltage supply whereby a p-n junction is formed within the second polycrystalline interconnect layer (22) to provide a diode connection between the resistor and the positive voltage supply.

2. The structure of claim 1, wherein the first conductivity type is n-type, and the second conductivity type is p-type.

3. The structure of claim 1, wherein the first conductivity type is p-type, and the second conductivity type is n-type.

4. The structure of claim 1, wherein the first and second conductivity types are of the same type, and wherein the second polycrystalline silicon layer (22) is lightly doped relative to the first polycrystalline silicon layer (14).

5. The structure of claim 1, wherein said second polycrystalline silicon interconnect layer (22) is lightly doped in the contact opening (20).

6. The structure of claim 5, wherein the first and second conductivity types are of opposite type and the first and third conductivity types are of the same type.

7. A method of fabricating an SRAM cell comprising:
first and second cross-coupled transistors (30,32) and first and second access transistors (34,36), said cross-coupled transistors (30,32) each being field-effect transistors having respective gates, sources and drains, the gate of said first cross-coupled transistor (30) being connected to the drain of said second cross-coupled transistor (32) and the gate of said second cross-coupled transistor (32) being connected to the drain of said first cross-coupled transistor (30); and
first and second load elements respectively connecting the drains of said first and second cross-coupled transistors (30,32) to a positive voltage supply; characterised in that the first and second load elements each comprise a contact structure formed by the method steps of:
forming a first polycrystalline silicon interconnect layer (14) of a first conductivity type;
forming a silicide layer (16) on the first polycrystalline silicon interconnect layer (14);
forming an insulating layer (18) over the entire device;
forming a contact opening (20) in the insulating layer (18) wherein a contact region on an upper surface of the silicide layer (16) is exposed;
forming a second polycrystalline silicon interconnect layer (22) of a second conductivity type over the insulating layer (18), wherein the second polycrystalline silicon interconnect layer (22) makes ohmic contact with the silicide layer (16) through the contact opening (20) thereby providing a resistor connection to the drain of the respective cross-coupled transistor; and
forming a doped region (24) of a third conductivity type within the second polycrystalline silicon interconnect layer (22) at a location spaced from the contact opening (20), the doped region (24) of a third conductivity type being more heavily doped than the second polycrystalline interconnect layer and being connected to the positive voltage supply whereby a p-n junction (26) is formed within the second polycrystalline silicon interconnect layer (22) thereby to provide a diode connection between the resistor and the positive voltage supply.

8. The method of claim 7, wherein the first and second conductivity types are of the same type, and the second polycrystalline silicon interconnect layer (22) is lightly doped relative to the first polycrystalline silicon interconnect layer (14).

9. The method of claim 7, wherein the first and second conductivity types are of opposite type and the first and third conductivity types are of the same type.

## Patentansprüche

1. Eine SRAM-Zelle mit:
ersten und zweiten kreuzgekoppelten Transistoren (30,32) und ersten und zweiten Zugriffstransistoren (34,36), wobei die kreuzgekoppelten Transistoren (30,32) jeweils Feldeffekt-Transistoren mit entsprechenden Gate-, Source- und Drain-Elektroden sind, die Gate-Elektrode des ersten kreuzgekoppelten Transistors (30) mit der Drain-Elektrode des zweiten kreuzgekoppelten Transistors (32) und die Gate-Elektrode des zweiten kreuzgekoppelten Transistors (32) mit der Drain-Elektrode des ersten kreuzgekoppelten Transistors (30) verbunden ist; und
ersten und zweiten Lastelementen, die jeweils die Drain-Elektroden des ersten und des zweiten kreuzgekoppelten Transistors (30,32) mit einer positiven Spannungsversorgung verbinden;
dadurch gekennzeichnet, daß das erste und das zweite Lastelement jeweils eine Kontaktstruktur aufweisen mit: einer ersten Zwischenverbindungsschicht (14) aus polykristallinem Silizium eines ersten Leitfähigkeitstyps, die mit der Drain-Elektrode des entsprechenden kreuzgekoppelten Transistors verbunden ist;
einer Silizidschicht (16) auf der ersten Schicht (14) aus polykristallinem Silizium;
einer Isolationsschicht (18), die über der Schicht (14) aus polykristallinem Silizium und der Silizidschicht (16) liegt, wobei die Isolationsschicht (18) eine Kontaktöffnung (20) darin aufweist, welche einen Abschnitt einer oberen Fläche der Silizidschicht (16) freilegt;
einer zweiten Zwischenverbindungsschicht (22) aus polykristallinem Silizium eines zweiten Leitfähigkeitstyps, die über einem Abschnitt der Isolationsschicht (18) liegt und die Silizidschicht (16) in der Kontaktöffnung (20) kontaktiert, wodurch ein Ohm'scher Kontakt in der Kontaktöffnung (20) zum Bereitstellen einer Widerstandsverbindung zu der Drain-Elektrode des entsprechenden kreuzgekoppelten Transistors ausgebildet wird; und
einem dotierten Bereich (24) eines dritten Leitfähigkeitstyps in der zweiten polykristallinen Zwischenverbindungsschicht (22) an einer Stelle, die von der Kontaktöffnung (20) beabstandet ist, wobei der dotierte Bereich (24) eines dritten Leitfähigkeitstypes stärker dotiert ist als die zweite polykristalline Zwischenverbindungsschicht (2) und mit der positiven Spannungsversorgung verbunden ist, wodurch ein pn-Übergang innerhalb der zweiten polykristallinen Zwischenverbindungsschicht (22) ausgebildet wird, um eine Diodenverbindung zwischen dem Widerstand und der positiven Spannungsversorgung zu schaffen.

2. Struktur nach Anspruch 1, bei welcher der erste Leitfähigkeitstyp vom n-Typ und der zweite Leitfähigkeitstyp vom p-Typ ist.

3. Struktur nach Anspruch 1, bei welcher der erste Leitfähigkeitstyp vom p-Typ und der zweite Leitfähigkeitstyp vom n-Typ ist.

4. Struktur nach Anspruch 1, bei welcher der erste und der zweite Leitfähigkeitstyp vom selben Typ sind und wobei die zweite Schicht (22) aus polykristallinem Silizium relativ zu der ersten Schicht (14) aus polykristallinem Silizium gering dotiert ist.

5. Struktur nach Anspruch 1, bei welcher die zweite Zwischenverbindungsschicht (22) aus polykristallinem Silizium in der Kontaktöffnung (20) gering dotiert ist.

6. Struktur nach Anspruch 5, bei welcher der erste und der zweite Leitfähigkeitstyp vom entgegengesetzten Typ sind und der erste und der dritte Leitfähigkeitstyp vom selben Typ sind.

7. Verfahren zur Herstellung einer SRAM-Zelle mit:
ersten und zweiten kreuzgekoppelten Transistoren (30,32) und ersten und zweiten Zugriffstransistoren (34,36), wobei die kreuzgekoppelten Transistoren (30,32) jeweils Feldeffekt-Transistoren mit entsprechenden Gate-, Source- und Drain-Elektroden sind, die Gate-Elektrode des ersten kreuzgekoppelten Transistors (30) mit der Drain-Elektrode des zweiten kreuzgekoppelten Transistors (32) und die Gate-Elektrode des zweiten kreuzgekoppelten Transistors (32) mit der Drain-Elektrode des ersten kreuzgekoppelten Transistors (30) verbunden ist; und
ersten und zweiten Lastelementen, die jeweils die Drain-Elektroden des ersten und des zweiten kreuzgekoppelten Transistors (30,32) mit einer positiven Spannungsversorgung verbinden; dadurch gekennzeichnet, daß das erste und das zweite Lastelement jeweils eine Kontaktstruktur aufweisen, die durch die Verfahrensschritte ausgebildet wird: Ausbilden einer ersten Zwischenverbindungsschicht (14) aus polykristallinem Silizium eines ersten Leitfähigkeitstyps; Ausbilden einer Silizidschicht (16) auf der ersten Zwischenverbindungsschicht (14) aus polykristallinem Silizium;
Ausbilden einer Isolationsschicht (18) über dem gesamten Bauelement;
Ausbilden einer Kontaktöffnung (20) in der Isolationsschicht (18), wobei ein Kontaktbereich auf einer oberen Fläche der Silizidschicht (16) freigelegt wird;
Ausbilden einer zweiten Zwischenverbindungsschicht (22) aus polykristallinem Silizium eines zweiten Leitfähigkeitstyps über der Isolationsschicht (18), wobei die zweite Zwischenverbindungsschicht (22) aus polykristallinem Silizium einen Ohm'schen Kontakt mit der Silizidschicht (16) durch die Kontaktöffnung (20) herstellt, wodurch eine Widerstandsverbindung zu der Drain-Elektrode des entsprechenden kreuzgekoppelten Transistors geschaffen wird; und Ausbilden eines dotierten Bereichs (24) eines dritten Leitfähigkeitstyps innerhalb der Zwischenverbindungsschicht (22) aus polykristallinem Silizium an einer Stelle, die von der Kontaktöffnung (20) beabstandet ist, wobei der dotierte Bereich (24) eines dritten Leitfähigkeitstyps stärker dotiert ist als die zweite polykristalline Zwischenverbindungsschicht und mit der positiven Spannungsversorgung verbunden ist, wodurch ein pn-Übergang (26) innerhalb der zweiten Zwischenverbindungsschicht (22) aus polykristallinem Silizium ausgebildet wird, um eine Diodenverbindung zwischen dem Widerstand und der positiven Spannungsversorgung zu schaffen.

8. Verfahren nach Anspruch 7, bei welchem der erste und der zweite Leitfähigkeitstyp vom selben Typ sind und die zweite Zwischenverbindungsschicht (22) aus polykristallinem Silizium relativ zu der ersten Zwischenverbindungsschicht (14) aus polykristallinem Silizium gering dotiert ist.

9. Verfahren nach Anspruch 7, bei welchem der erste und der zweite Leitfähigkeitstyp vom entgegengesetzten Typ sind und der erste und der dritte Leitfähigkeitstyp vom selben Typ sind.

## Revendications

1. Cellule de SRAM comprenant :
des premier et second transistors connectés transversalement (30, 32) et des premier et second transistors d'accès (34, 36), lesdits transistors connectés transversalement (30, 32) étant chacun des transistors à effet de champ ayant des grilles, des sources et des drains respectifs, la grille dudit premier transistor connecté transversalement (30) étant connectée au drain dudit second transistor connecté transversalement (32) et la grille dudit second transistor connecté transversalement (32) étant connectée au drain dudit premier transistor connecté transversalement (30) ; et
des premier et second éléments de charge connectant respectivement les drains desdits premier et second transistors connectés transversalement (30, 32) à une tension d'alimentation positive ;
caractérisé en ce que les premier et second éléments de charge comprennent chacun une structure de contact comportant :
une première couche d'interconnexion en silicium polycristallin (14) d'un premier type de conductivité connectée au drain du transistor connecté transversalement respectif ;
une couche de siliciure (16) sur ladite première couche en silicium polycristallin (14) ;
une couche isolante (18) recouvrant ladite première couche en silicium polycristallin (14) et ladite couche de siliciure (16), ladite couche isolante (18) ayant une ouverture de contact (20) qui expose une partie d'une surface supérieure de ladite couche de siliciure (16) ;
une seconde couche d'interconnexion en silicium polycristallin (22) d'un deuxième type de conductivité recouvrant une partie de ladite couche isolante (18) et étant en contact avec ladite couche de siliciure (16) dans l'ouverture de contact (20), dans laquelle un contact ohmique est formé dans l'ouverture de contact (20) pour réaliser une connexion de résistance avec le drain du transistor connecté transversalement respectif ; et
une zone dopée (24) d'un troisième type de conductivité dans la seconde couche d'interconnexion en silicium polycristallin (22) à un emplacement distant de l'ouverture de contact (20), la zone dopée (24) d'un troisième type de conductivité étant plus fortement dopée que la seconde couche d'interconnexion en silicium polycristallin (22) et étant connectée à la tension d'alimentation positive, ce par quoi une jonction p-n est formée dans la seconde couche d'interconnexion en silicium polycristallin (22) pour réaliser une connexion de diode entre la résistance et la tension d'alimentation positive.

2. Structure de la revendication 1, dans laquelle le premier type de conductivité est du type n, et dans laquelle le deuxième type de conductivité est du type p.

3. Structure de la revendication 1, dans laquelle le premier type de conductivité est du type p, et dans laquelle le deuxième type de conductivité est du type n.

4. Structure de la revendication 1, dans laquelle les premier et deuxième types de conductivité sont du même type, et dans laquelle la seconde couche en silicium polycristallin (22) est faiblement dopée par rapport à la première couche en silicium polycristallin (14).

5. Structure de la revendication 1, dans laquelle ladite seconde couche d'interconnexion en silicium polycristallin (22) est faiblement dopée dans l'ouverture de contact (20).

6. Structure de la revendication 5, dans laquelle les premier et deuxième types de conductivité sont de type contraire, et dans laquelle les premier et troisième types de conductivité sont du même type.

7. Procédé de fabrication d'une cellule de SRAM comprenant :
des premier et second transistors connectés transversalement (30, 32) et des premier et second transistors d'accès (34, 36), lesdits transistors connectés transversalement (30, 32) étant chacun des transistors à effet de champ ayant des grilles, des sources et des drains respectifs, la grille dudit premier transistor connecté transversalement (30) étant connectée au drain dudit second transistor connecté transversalement (32) et la grille dudit second transistor connecté transversalement (32) étant connectée au drain dudit premier transistor connecté transversalement (30) ; et
des premier et second éléments de charge connectant respectivement les drains desdits premier et second transistors connectés transversalement (30, 32) à une tension d'alimentation positive ; caractérisé en ce que les premier et second éléments de charge comprennent chacun une structure de contact formée par les étapes de procédé consistant à :
former une première couche d'interconnexion de silicium polycristallin (14) d'un premier type de conductivité ;
former une couche de siliciure (16) sur la première couche d'interconnexion en silicium polycristallin (14) ;
former une couche isolante (18) sur le dispositif entier ;
former une ouverture de contact (20) dans la couche isolante (18) dans laquelle une zone de contact sur une surface supérieure de la couche de siliciure (16) est exposée ;
former une seconde couche d'interconnexion en silicium polycristallin (22) d'un deuxième type de conductivité sur la couche isolante (18), dans laquelle la seconde couche d'interconnexion en silicium polycristallin (22) réalise un contact ohmique avec la couche de siliciure (16) à travers l'ouverture de contact (20), réalisant par ce moyen une connexion de résistance avec le drain du transistor connecté transversalement respectif ; et à
former une zone dopée (24) d'un troisième type de conductivité dans la seconde couche d'interconnexion en silicium polycristallin (22) à un emplacement distant de l'ouverture de contact (20), la zone dopée (24) d'un troisième type de conductivité étant plus fortement dopée que la seconde couche d'interconnexion en silicium polycristallin et étant connectée à la tension d'alimentation positive, ce par quoi une jonction p-n (26) est formée dans la seconde couche d'interconnexion en silicium polycristallin (22), pour réaliser par ce moyen une connexion de diode entre la résistance et la tension d'alimentation positive.

8. Procédé de la revendication 7, dans lequel les premier et deuxième types de conductivité sont du même type, et dans lequel la seconde couche d'interconnexion de silicium polycristallin (22) est faiblement dopée par rapport à la première couche d'interconnexion en silicium polycristallin (14).

9. Procédé de la revendication 7, dans lequel les premier et deuxième types de conductivité sont de type contraire et dans lequel les premier et troisième types de conductivité sont du même type.
